# EUROPEAN PATENT APPLICATION

(11) **EP 2 765 582 A1**
(43) Date of publication of application: **13.08.2014**
(21) Application number: 11873584.4
(22) Date of filing: 08.12.2011
(51) Int. Cl.: H01B 5/14, H01B 1/00

(54) **ONE-DIMENSIONAL CONDUCTIVE NANOMATERIAL-BASED CONDUCTIVE FILM HAVING THE CONDUCTIVITY THEREOF ENHANCED BY A TWO-DIMENSIONAL NANOMATERIAL**

(30) Priority: 06.10.2011 KR 20110101907
(71) Applicant: Korea Electro Technology Research Institute, Gyeongsangnam-do 641-120 (KR)
(72) Inventor: HAN, Joong-Tark, Changwon-si Gyeongsangnam-do 641-120 (KR); LEE, Geon-Woong, Changwon-si Gyeongsangnam-do 641-120 (KR); JEONG, Hee-Jin, Changwon-si Gyeongsangnam-do 641-120 (KR); JEONG, Seung-Yol, Changwon-si Gyeongsangnam-do 641-120 (KR); KIM, Jun-Suk, Changwon-si Gyeongsangnam-do 641-120 (KR)
(74) Representative: Patronus IP Patent- und Rechtsanwälte
(86) International application number: PCT/KR2011/009444
(87) International publication number: WO 2013/051758

(57) **Abstract**

The present invention relates to a one-dimensional conductive nanomaterial-based conductive film having the conductivity thereof enhanced by a two-dimensional nanomaterial in which the conductive film includes a substrate, a one-dimensional conductive nanomaterial layer formed on the substrate, and a two-dimensional nanomaterial layer formed on the one-dimensional conductive nanomaterial layer, wherein the one-dimensional conductive nanomaterial layer includes a one-dimensional conductive nanomaterial formed of at least one selected from a carbon nanotube, a metal nanowire, and a metal nanorod, and the two-dimensional nanomaterial layer includes a two-dimensional nanomaterial formed of at least one selected from graphene, boron nitride, tungsten oxide (WO₃), molybdenum sulfide (MoS₂), molybdenum telluride (MoTe₂), niobium diselenide (NbSe₂), tantalum diselenide (TaSe₂), and manganese dioxide (MnO₂). According to the present invention, graphene or the like, which is a two-dimensional nanomaterial, may be stacked on a one-dimensional conductive nanomaterial such as a carbon nanotube or a metal nanowire to enhance the conductivity of the one-dimensional conductive nanomaterial film.

## Description

### Technical Field

The present invention relates to a one-dimensional conductive nanomaterial-based conductive film having conductivity thereof enhanced by a two-dimensional nanomaterial. More particularly, the present invention relates to a one-dimensional conductive nanomaterial-based conductive film, wherein the conductivity thereof is enhanced by laminating a two-dimensional nanomaterial, such as graphene or the like, on the upper surface of a film composed of a one-dimensional conductive nanomaterial such as carbon nanotubes, metal nanowires or the like.

### Background Art

Generally, a transparent conductive film is used in plasma display panels (PDPs), liquid crystal displays (LCDs), light-emitting diodes (LEDs), organic light-emitting diodes (OLEDs), touch panels, solar cells, and the like.

Such a transparent conductive film is used as electrodes of solar cells, liquid crystal displays, plasma display panels, smart windows and various light-receiving and light-emitting devices, and is used as antistatic films for automobile window glass or building window glass, transparent electromagnetic wave shielding films, heat reflection films, transparent heating elements for refrigerating showcases, and the like, because this transparent conductive film has high conductivity (for example, surface resistance: 1x10³ Ω/sq or less) and high visible light transmission.

As a transparent conductive film, a tin oxide (SnO₂) film doped with antimony or fluorine, a zinc oxide (ZnO) film doped with aluminum or potassium, an indium oxide (In₂O₃) film doped with tin, and the like are widely used.

Particularly, an indium oxide film doped with tin, that is, an In₂O₃-Sn film, is referred to as an indium tin oxide (ITO) film, and is generally used because it has low resistance. The ITO film is advantageous in that it has excellent physical properties, and, to date, it has frequently been introduced in processes, but is problematic in that the supply and demand of indium oxide (In₂O₃) is unstable because indium oxide (In₂O₃) is produced as a by-product from a zinc (Zn) mine or the like. Further, the ITO film is problematic in that it cannot be used for a flexible substrate, such as a polymer substrate or the like, because it does not have flexibility, and in that its production cost is high because it must be prepared at high-temperature and high-pressure conditions.

Meanwhile, in order to obtain a flexible display, a flexible conductive film prepared by coating a polymer substrate with a conductive polymer may be used. However, such a flexible conductive film is problematic in that its electrical conductivity is deteriorated when it is exposed to an external environment, and it is not transparent, thus restricting the use thereof.

In order to solve the above problems, technologies of coating various kinds of substrates with carbon nanotubes have recently been researched. Carbon nanotubes are advantageous in that they have electrical conductivity next to that of metal because they have a low electrical resistance of 10⁻⁴ Ωcm, their surface area is 1000 times or more larger than that of a bulk material, and their length is several thousands of times longer than their outer diameter, and thus they are ideal materials in terms of conductivity realization, and in that the bonding force thereof to a substrate can be improved by surface functionalization. Particularly, since carbon nanotubes can be used for a flexible substrate, it expected that the use thereof will be infinite.

As a conventional carbon nanotube-using technology, there is "a carbon nanotube-containing coating film" (Korean Application Publication No. 10-2004-0030553). This conventional technology is problematic in that only carbon nanotubes having an outer diameter of 3.5 nm can be used in consideration of dispersibility and electrical conductivity, and thus the usage thereof is restricted, and in that the dispersibility and adhesivity of carbon nanotubes are deteriorated at the time of forming a coating film, and thus the characteristics of the coating film are deteriorated with the passage of time.

As another conventional technology, Korean Patent Registration No. 10-869163 discloses "a method of manufacturing a transparent conductive film containing carbon nanotubes and a binder, and a transparent conductive film manufactured thereby".

This conventional technology is configured such that acid-treated carbon nanotubes having an outer diameter of less than 15 nm are mixed with a binder (Here, the binder is added in an amount of 15 to 80 parts by weight, based on 100 parts by weight of the mixture) to obtain a carbon nanotube-binder mixed coating solution, and then the mixed coating solution is applied onto a substrate, thereby forming a transparent conductive film.

This conventional technology is also problematic in that the packing density of a carbon nanotube network is not high, so junction resistance increases, thereby decreasing conductivity, and in that carbon nanotubes have hydrophobicity, and thus it is difficult to apply a hydrophilic material onto carbon nanotubes.

Further, this conventional technology is problematic in that carbon nanotubes have pores on the surface thereof, so the surface thereof becomes rough, and thus there is a limitation in using carbon nanotubes as photoelectric elements.

### Disclosure

### Technical Problem

Accordingly, the present invention has been made to solve the above-mentioned problems, and an object of the present invention is to provide a one-dimensional conductive nanomaterial-based conductive film, wherein the conductivity thereof is enhanced by laminating a two-dimensional nanomaterial, such as graphene or the like, on the upper surface of a film composed of a one-dimensional conductive nanomaterial such as carbon nanotubes, metal nanowires or the like.

### Technical Solution

In order to accomplish the above object, an aspect of the present invention provides a one-dimensional conductive nanomaterial-based conductive film, the conductivity of which is enhanced by a two-dimensional nanomaterial, including: a substrate; a one-dimensional conductive nanomaterial layer formed on the substrate; and a two-dimensional nanomaterial layer formed on the one-dimensional conductive nanomaterial layer, wherein the one-dimensional conductive nanomaterial layer is formed of at least one one-dimensional conductive nanomaterial selected from among carbon nanotubes, metal nanowires and metal nanorods, and the two-dimensional nanomaterial layer is formed of at least one two-dimensional nanomaterial selected from among graphene, boron nitride, tungsten oxide (WO₃), molybdenum sulfide (MoS₂), molybdenum telluride (MoTe₂), niobium diselenide (NbSe₂), tantalum diselenide (TaSe₂) and manganese oxide (MnO₂).

Here, the substrate may be made of any one selected from the group consisting of glass, quartz, a glass wafer, a silicon wafer, and plastic.

The one-dimensional conductive nanomaterial layer may be formed by dispersing a one-dimensional conductive material in a solvent to obtain a one-dimensional conductive material solution and then applying the solution onto the substrate. The application of the solution may be performed using one method selected from among spraying, dipping, spin coating, screen printing, inkjet printing, pad printing, knife coating, kiss coating, and gravure coating.

The two-dimensional nanomaterial may be graphene oxide. The two-dimensional nanomaterial layer may be formed by acid-treating pure graphite to obtain graphite oxide, stripping the graphite oxide to form graphene oxide and then applying the graphene oxide onto the one-dimensional conductive nanomaterial layer. Here, as the acid treatment, Staudenmaier method (L. Staudenmaier, Ber. Dtsch. Chem. Ges., 31, 1481-1499, 1898), Hummers method (W. Hummers et al 1, J. Am. Chem. Soc., 80, 1339, 1958), Brodie method (B. C. Brodie, Ann. Chim. Phys., 59, 466-472, 1860) and other modified methods for effectively oxidizing and stripping graphite are known. In the present invention, these methods are used.

The application of the graphene oxide may be performed using one method selected from among spraying, dipping, spin coating, screen printing, inkjet printing, pad printing, knife coating, kiss coating, gravure coating, and offset coating.

Accordingly, there is an advantage of enhancing the conductivity of a one-dimensional conductive nanomaterial film by laminating a two-dimensional nanomaterial, such as graphene or the like, on the upper surface of a film composed of a one-dimensional conductive nanomaterial such as carbon nanotubes, metal nanowires, metal nanorods or the like.

### Advantageous Effects

According to the present invention, there is an effect of enhancing the conductivity of a one-dimensional conductive nanomaterial film by laminating a two-dimensional nanomaterial, such as graphene or the like, on the upper surface of a film composed of a one-dimensional conductive nanomaterial such as carbon nanotubes, metal nanowires, metal nanorods or the like.

### Description of Drawings

FIG. 1 is a scanning microscope photograph of a carbon nanotube film formed on a substrate;
FIG. 2 is a schematic view showing a procedure of laminating a two-dimensional nanomaterial on a one-dimensional conductive nanomaterial;
FIG. 3 is a scanning microscope photograph of graphene oxide as a two-dimensional nanomaterial;
FIG. 4 shows graphs showing the results of analyzing graphene oxide as a two-dimensional nanomaterial using an X-ray photoelectric spectrometer (a) and an infrared spectrometer (b);
FIG. 5 is a graph showing the surface resistance of a carbon nanotube transparent conductive film to transmittance before and after coating the film with graphene oxide;
FIG. 6 shows scanning electron microscope photographs of the surface morphology of a carbon nanotube transparent conductive film depending on carbon nanotube coating and the water contact angle on the surface thereof;
FIG. 7 is a graph showing the Raman spectrum of carbon nanotubes depending on graphene oxide coating according to the present invention;
FIG. 8 is a schematic view showing the change in network of carbon nanotubes depending on graphene oxide coating according to the present invention;
FIG. 9 shows views showing an organic solar cell (a) fabricated using a carbon nanotube transparent conductive film, which controls conductivity using graphene, as an electrode, and the characteristics thereof (b) according to the present invention; and
FIG. 10 is a scanning microscope photograph of boron nitride as a two-dimensional nanomaterial.

### Mode for Invention

Hereinafter, preferred embodiments of the present invention will be described in detail with reference to the accompanying drawings.

### <First embodiment >

First, a one-dimensional conductive nanomaterial layer will be described.

The one-dimensional conductive nanomaterial layer is formed on a plastic substrate using a one-dimensional conductive nanomaterial. In this embodiment, as the substrate, a polyethylene terephthalate substrate is used. Further, as the one-dimensional conductive nanomaterial, carbon nanotubes, metal nanowires, metal nanorods or the like may be used, but, in this embodiment, carbon nanotubes are used.

First, 1 mg of single-wall carbon nanotubes are added to 100 mL of a surfactant solution (concentration: 1%), the carbon nanotubes are dispersed for 1 hour using a sonicator, and then the surfactant solution dispersed with carbon nanotubes is treated by a centrifugal separator at a rotation speed of 100 rpm for 30 min to separate upper-layer liquid, thereby preparing a carbon nanotube solution.

Subsequently, the prepared carbon nanotube solution is applied onto a polyethylene terephthalate substrate using a spray coater.

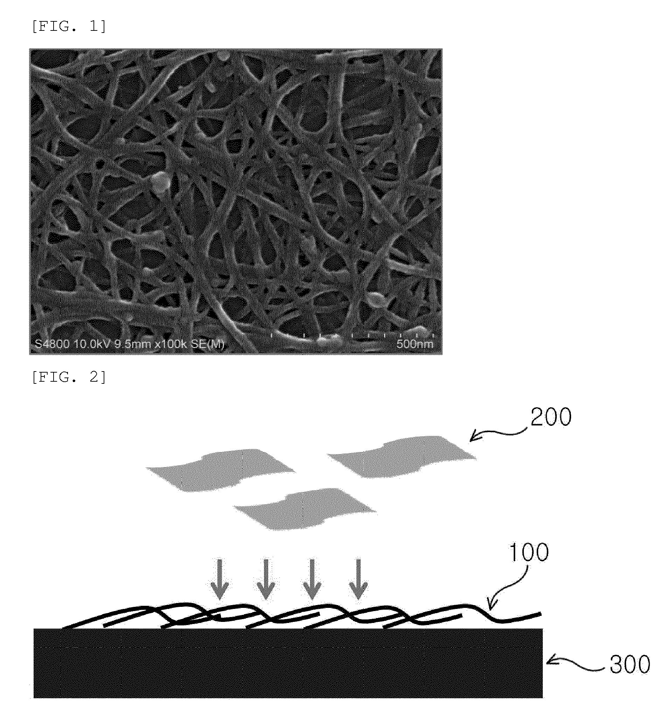

Through this procedure, the substrate is formed thereon with a carbon nanotube transparent conductive film, which is a one-dimensional conductive nanomaterial layer. In this case, a surfactant remains on the transparent conductive film. Therefore, when the surfactant is removed using distilled water, finally, a carbon nanotube transparent conductive film is formed as shown in FIG. 1.

Subsequently, a two-dimensional nanomaterial layer is formed on the one-dimensional conductive nanomaterial layer.

FIG. 2 is a schematic view showing a procedure of laminating a two-dimensional nanomaterial on a one-dimensional conductive nanomaterial. In this embodiment, graphene oxide is used as the two-dimensional nanomaterial.

Graphene oxide is prepared by stripping graphite oxide using a sonicator, wherein the graphite oxide is prepared by treating pure graphite with sulfuric acid and KMnO₄ for 1 day and then purifying the treated graphite with hydrogen peroxide and hydrochloric acid.

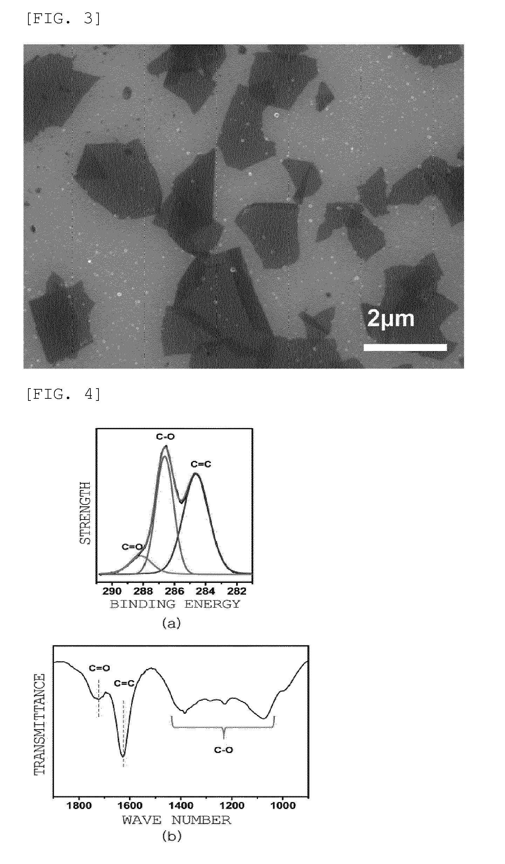

The prepared graphene oxide is a single layer as shown in FIG. 3, and, as the results of analyzing the graphene oxide using an X-ray photoelectric spectrometer and an infrared spectrometer, it can be ascertained that the graphene oxide is an oxide-type graphene.

The prepared oxide graphene is applied onto a carbon nanotube transparent conductive film, which is a one-dimensional nanomaterial layer, using a spray coater, thus forming a one-dimensional conductive nanomaterial-based conductive film, the conductivity thereof being enhanced by a two-dimensional nanomaterial.

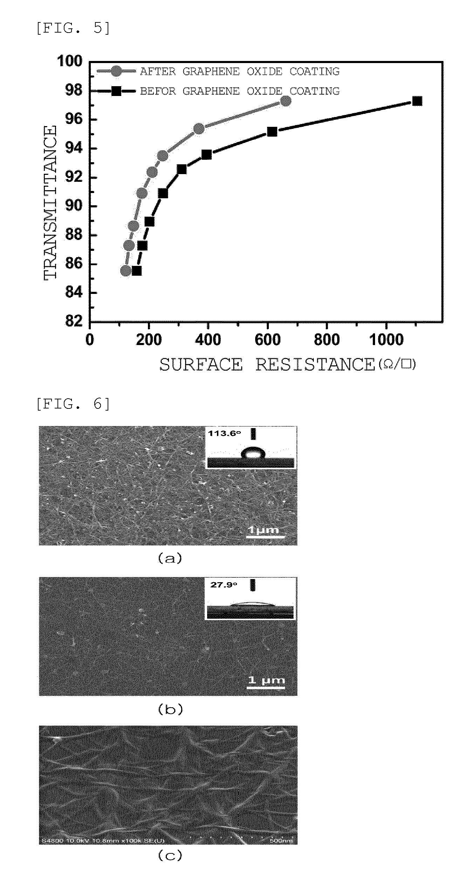

FIG. 5 is a graph showing the surface resistance of a carbon nanotube transparent conductive film to transmittance before and after coating the film with graphene oxide.

As shown in FIG. 5, it can be ascertained that, when the carbon nanotube transparent conductive film is coated with graphene oxide, the surface resistance of the transparent conductive film under the same transmittance decreases, compared to therebefore. That is, it is understood that, when graphene oxide, as a two-dimensional nanomaterial layer, is applied onto the carbon nanotube transparent conductive film, the surface resistance of the transparent conductive film is lowered under the same transmittance, compared to before graphene oxide is applied. For this reason, it is understood that graphene oxide increases the packing density of a carbon nanotube network to decrease the junction resistance thereof, thereby increasing the conductivity of the carbon nanotube transparent conductive film.

Next, in order to observe the water contact angle of a carbon nanotube transparent conductive film according to the application of graphene oxide, FIG. 6 shows scanning electron microscope photographs of the surface morphology of a carbon nanotube transparent conductive film depending on carbon nanotube coating and the water contact angle on the surface thereof.

FIG. 6A is a scanning electron microscope photograph of the surface morphology of only a carbon nanotube transparent conductive film, and FIG. 6B is a scanning electron microscope photograph of the surface morphology of a carbon nanotube transparent conductive film coated with graphene oxide, and FIG. 6C is a partially enlarged view of the surface morphology of the carbon nanotube transparent conductive film of FIG. 6B.

From FIGS. 6A and 6B, it can be ascertained that, as shown in FIG. 6A, the water contact angle was 113.6° before the application of graphene oxide, but was 27.9° after the application of graphene oxide, thus improving the wettability of the carbon nanotube transparent conductive film to water.

Further, as shown in FIG. 6C, it can be ascertained that graphene oxide is uniformly applied on carbon nanotubes, and thus graphene oxide makes a carbon nanotube network more compact.

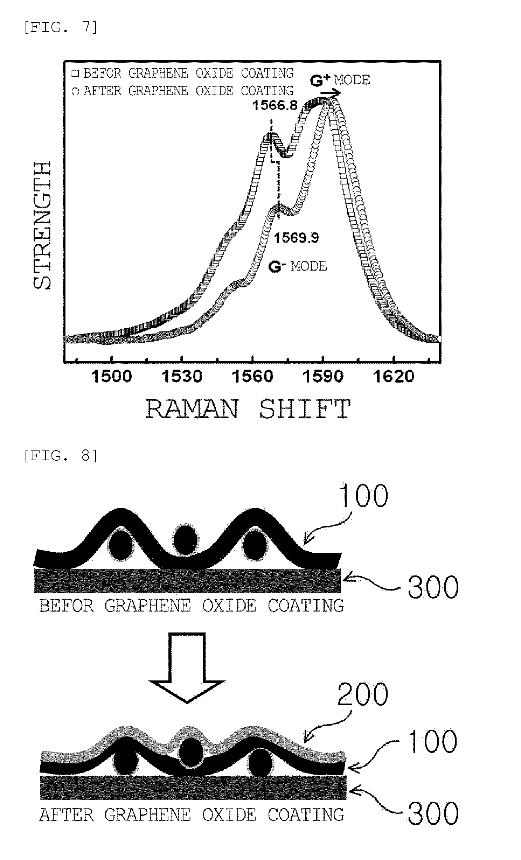

FIG. 7 is a graph showing the Raman spectrum of carbon nanotubes depending on graphene oxide coating according to the present invention, and FIG. 8 is a schematic view showing the change in network of carbon nanotubes depending on graphene oxide coating according to the present invention.

As shown in FIG. 7, in the Raman spectrum of carbon nanotubes, the transformation of carbon nanotubes can be observed through the change in the G mode band. That is, it can be ascertained that the peak of the G-mode is shifted right according to the application of graphene oxide.

Such a phenomenon is based on the fact that, as shown in FIG. 8, when graphene oxide is applied on carbon nanotubes, a carbon nanotube network is made more compact, and electrons are attracted, thus exhibiting a doping effect.

Additionally explaining the fact, when the prepared carbon nanotube transparent conductive film is coated with graphene oxide using a spray coater, as shown in FIG. 8, a carbon nanotube network becomes more compact than before the application of graphene oxide, so junction resistance between carbon nanotubes decreases, and carbon nanotubes are doped with graphene oxide directly making contact therewith, thereby decreasing the surface resistance of the carbon nanotube transparent conductive film.

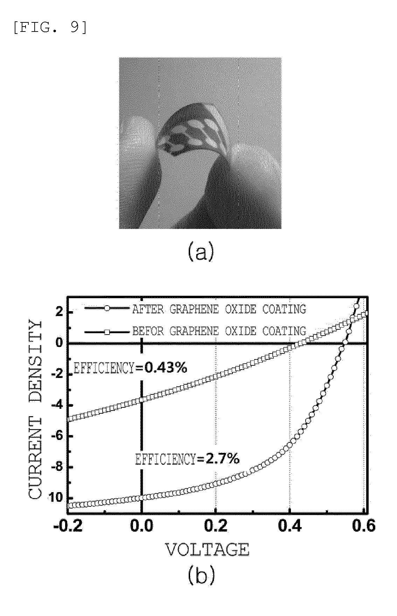

FIG. 9 shows views showing an organic solar cell (a) fabricated using a carbon nanotube transparent conductive film, which controls conductivity using graphene, as an electrode, and the characteristics thereof (b) according to the present invention.

As shown in FIG. 9A, a flexible solar cell was fabricated using a carbon nanotube transparent conductive film as an electrode. As shown in FIG. 9B, it can be ascertained that, when a carbon nanotube transparent conductive film not coated with graphene oxide was used as an electrode, the photoelectric efficiency thereof was only 0.43%, but, when a carbon nanotube transparent conductive film coated with graphene oxide to have improved conductivity and wettability was used as an electrode, the photoelectric efficiency thereof was greatly increased to 2.7%.

### <Second embodiment>

In second embodiment of the present invention, a carbon nanotube transparent conductive film was formed in the same manner as in first embodiment, except that boron nitride was used as a two-dimensional nanomaterial.

Boron nitride, similarly to graphite, is structured such that two-dimensional boron nitride layers are piled in layers.

In this embodiment, boron nitride was dispersed in an organic solvent such as alcohol or the like, and then treated with a sonicator and a homogenizer to prepare a two-dimensional boron nitride coating solution, and then the two-dimensional boron nitride coating solution is formed into a boron nitride sheet.

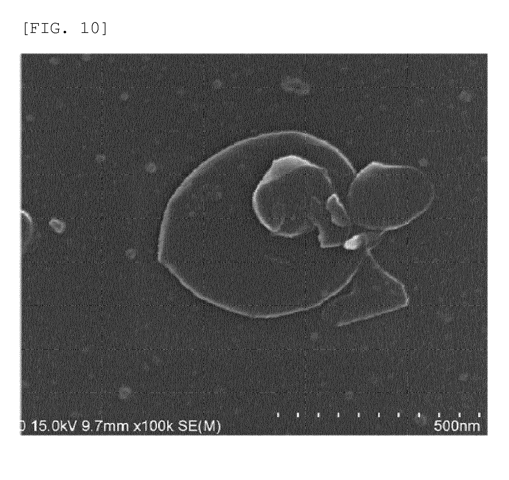

FIG. 10 is a scanning electron microscope photograph of the formed two-dimensional boron nitride sheet. From FIG. 10, it can be ascertained that two-dimensional boron nitride sheet is a single layer.

The prepared boron nitride coating solution was applied onto a carbon nanotube transparent conductive film to form a two-dimensional nanomaterial layer. Similarly to the carbon nanotube transparent conductive film coated with graphene oxide in the first embodiment, the surface resistance of the nanotube transparent conductive film coated with boron nitride was lowered.

### Industrial Applicability

The present invention relates to a one-dimensional conductive nanomaterial-based conductive film having conductivity thereof enhanced by a two-dimensional nanomaterial. More particularly, the present invention relates to a one-dimensional conductive nanomaterial-based conductive film, the conductivity of which is enhanced by laminating a two-dimensional nanomaterial, such as graphene or the like, on the upper surface of a film composed of a one-dimensional conductive nanomaterial such as carbon nanotubes, metal nanowires or the like. This conductive film can be industrially applicable.

## Claims

1. A one-dimensional conductive nanomaterial-based conductive film, the conductivity of which is enhanced by a two-dimensional nanomaterial, comprising:
a substrate;
a one-dimensional conductive nanomaterial layer formed on the substrate; and
a two-dimensional nanomaterial layer formed on the one-dimensional conductive nanomaterial layer,
wherein the one-dimensional conductive nanomaterial layer is formed of at least one one-dimensional conductive nanomaterial selected from among carbon nanotubes, metal nanowires and metal nanorods, and the two-dimensional nanomaterial layer is formed of at least one two-dimensional nanomaterial selected from among graphene, boron nitride, tungsten oxide (WO₃), molybdenum sulfide (MoS₂), molybdenum telluride (MoTe₂), niobium diselenide (NbSe₂), tantalum diselenide (TaSe₂) and manganese oxide (MnO₂).

2. The one-dimensional conductive nanomaterial-based conductive film of claim 1, wherein the substrate is made of any one selected from the group consisting of glass, quartz, a glass wafer, a silicon wafer, and plastic.

3. The one-dimensional conductive nanomaterial-based conductive film of claim 1 or 2, wherein the one-dimensional conductive nanomaterial layer is formed by dispersing a one-dimensional conductive material in a solvent to obtain a one-dimensional conductive material solution and then applying the solution onto the substrate.

4. The one-dimensional conductive nanomaterial-based conductive film of claim 3, wherein the application of the solution is performed using one method selected from among spraying, dipping, spin coating, screen printing, inkjet printing, pad printing, knife coating, kiss coating, and gravure coating.

5. The one-dimensional conductive nanomaterial-based conductive film of claim 3, wherein the two-dimensional nanomaterial is graphene oxide.

6. The one-dimensional conductive nanomaterial-based conductive film of claim 5, wherein the two-dimensional nanomaterial layer is formed by acid-treating pure graphite to obtain graphite oxide, stripping the graphite oxide to form graphene oxide and then applying the graphene oxide onto the one-dimensional conductive nanomaterial layer.

7. The one-dimensional conductive nanomaterial-based conductive film of claim 6, wherein the application of the graphene oxide is performed using one method selected from among spraying, dipping, spin coating, screen printing, inkjet printing, pad printing, knife coating, kiss coating, gravure coating, and offset coating.
